# EUROPEAN PATENT APPLICATION

(11) **EP 4 246 743 A1**
(43) Date of publication of application: **20.09.2023**
(21) Application number: 21910701.8
(22) Date of filing: 20.12.2021
(51) Int. Cl.: H02B 1/40, H02B 1/42

(54) **ELECTRICAL DISCHARGE DETECTION SYSTEM**

(30) Priority: 22.12.2020 JP 2020212009; 22.12.2020 JP 2020212010
(71) Applicant: Nitto Kogyo Corporation, Nagakute-shi, Aichi 480-1189 (JP)
(72) Inventor: MIYAMOTO Atsushi, Nagakute-shi, Aichi 480-1189 (JP)
(74) Representative: Müller Schupfner & Partner Patent- und Rechtsanwaltspartnerschaft mbB
(86) International application number: PCT/JP2021/047020
(87) International publication number: WO 2022/138557

(57) **Abstract**

An electrical discharge detection system according to the present invention includes a parent machine 40 and a child machine 60. The parent machine 40 and the child machine 60 each comprise a noise detection unit 41, 61 that detects noise superimposed on a voltage or a current, and a determination unit 42, 62 that determines whether an electrical discharge has occurred, on the basis of the output of the noise detection unit 41, 61. The parent machine 40 is electrically connected to a secondary side of a main breaker 81 constituting a distribution board 8, and to primary sides of a plurality of branch breakers 82 constituting the same. The child machine 40 is electrically connected to an electrical outlet 91 that is provided in a building. The parent machine 40 outputs a first signal upon determining that an electrical discharge has occurred, and the first signal is inputted to at least one of the main breaker 81 and a branch breaker 82. The child machine 60 outputs a second signal upon determining that an electrical discharge has occurred, and the second signal is inputted to at least one of the parent machine 40, the main breaker 81, and a branch breaker 82.

## Description

### Technical Field

The present invention relates to a discharge detection system for detecting discharge occurred by an accident, such as tracking, a short circuit, and disconnection.

### Background Art

Japanese Patent Application Kokai Publication No. 2020-134231 (Patent Document 1) discloses a discharge detection unit provided in a distribution board. The discharge detection unit is electrically connected between a main breaker and branch breakers of the distribution board. The discharge detection unit is capable of monitoring occurrence of discharge in wiring of the entire building based on a noise generated by the discharge.

Japanese Patent Application Kokai Publication No. 2020-122669 (Patent Document 2) discloses a discharge detection unit provided with a plurality of noise detection sections corresponding to a plurality of branch breakers. Each of the plurality of noise detection sections is electrically connected to the secondary side of each of the plurality of branch breakers. The secondary side of each branch breaker is electrically connected to indoor wiring. By specifying the noise detection section having detected a noise, it is possible to specify the indoor wiring in which discharge has occurred.

### Prior Art Documents

### Patent Document

Patent Document 1: Japanese Patent Application Kokai Publication No. 2020-134231
Patent Document 2: Japanese Patent Application Kokai Publication No. 2020-122669

### Disclosure of the Invention

### Problems to be solved by the Invention

### Erroneous Determination of Discharge Occurrence

The level of a noise generated by discharge is attenuated in proportion to the length of wiring. Thus, a location of discharge occurrence farther from a discharge detection unit decreases the level of the noise input to the discharge detection unit. In such a case, a discharge detection unit in the past is capable of it detecting a noise at a low level by increasing the amplification factor of the amplifier. A discharge detection unit in the past is also capable of detecting a noise at a low level by reducing a threshold for determining whether discharge has occurred. However, an increase in the amplification factor or a decrease in the threshold causes the discharge detection unit to detect various noises other than the noise generated by discharge, thereby increasing cases of erroneously determining that discharge has occurred.

### Plurality of Noise Detection Sections

Meanwhile, the discharge detection unit provided with a plurality of noise detection sections takes a lot of time and effort to be installed in a distribution board. That is, each of the noise detection sections takes effort to be electrically connected to the secondary side of the corresponding branch breaker one by one. For example, when one of the noise detection sections is installed on the secondary side of the corresponding branch breaker, at first, the indoor wiring electrically connected to the secondary side of the branch breaker is detached. Then, the noise detection section is electrically connected to the secondary side of the branch breaker. The indoor wiring is then electrically connected to the secondary side of the noise detection section. Such installation work for the noise detection section has to be repeated the same number of times as the number of the branch breakers.

Moreover, to electrically connect the plurality of noise detection sections, a space has to be secured for storing the plurality of noise detection sections inside the housing of the distribution board. Since each noise detection section is installed on the secondary side of the corresponding one of the branch breakers, the gutter space (a space for connecting the wiring) in the distribution board has to be larger, and as a result, the housing of the distribution board becomes large.

### Objects of the Present Invention

It is an object of the present invention to provide a discharge detection system capable of thoroughly and accurately detecting discharge occurred in the entire building without reducing the discharge detection accuracy.

It is another object of the present invention to provide a discharge detection system that allows a plurality of discharge detectors (slave units) to be extremely readily installed and does not have to enlarge the housing of the distribution board.

### Means to solve the Problems

(1) To achieve the above object, a first discharge detection system of the present invention for detecting discharge occurred in a building based on a noise in a high frequency band input via indoor wiring, the discharge detection system includes a master unit and a slave unit, wherein each of the master unit and the slave unit is provided with a noise detection section for detecting the noise superimposed on a voltage or current and a determination section for determining whether discharge has occurred based on an output of the noise detection section, the master unit is electrically connected to a secondary side of a main breaker and primary sides of a plurality of branch breakers, the main breaker and the branch breakers configuring a distribution board, the slave unit is electrically connected to an electrical outlet installed in the building, each branch breaker has a secondary side electrically connected to the indoor wiring, the indoor wiring is electrically connected to the electrical outlet, if determining that discharge has occurred, the master unit outputs a first signal and the first signal is input to at least one of the main breaker and the branch breakers, and if determining that discharge has occurred, the slave unit outputs a second signal and the second signal is input to at least one of the master unit, the main breaker, and the branch breakers.
(2) It is preferred that, in the discharge detection system of (1) above, at least one of the main breaker and the branch breakers is interrupted based on at least one of the first signal and the second signal.
(3) To achieve the above object, a second discharge detection system of the present invention for detecting discharge occurred in a building based on a noise in a high frequency band input through indoor wiring, the discharge detection system includes a master unit and a slave unit, wherein each of the master unit and the slave unit is provided with a noise detection section for detecting the noise superimposed on a voltage or current, the master unit is further provided with a determination section for determining whether discharge has occurred based on an output of the noise detection section, the master unit is electrically connected to a secondary side of a main breaker and primary sides of a plurality of branch breakers, the main breaker and the branch breakers configuring a distribution board, the slave unit is electrically connected to an electrical outlet installed in the building, each branch breaker has a secondary side electrically connected to the indoor wiring, the indoor wiring is electrically connected to the electrical outlet, if determining that discharge has occurred, the master unit outputs a first signal and the first signal is input to at least one of the main breaker and the branch breakers, and an output of the noise detection section of the slave unit is input to at least one of the master unit, the main breaker, and the branch breakers.
(4) It is preferred that, in the discharge detection system of (3) above, at least one of the main breaker and the branch breakers is interrupted based on the first signal.
(5) It is preferred that, in the discharge detection system of (4) above, if determining that discharge has occurred based on the output of the noise detection section of the slave unit, the master unit outputs the first signal and the first signal is input to the slave unit.
(6) It is preferred that, in the discharge detection system of (3) above, the slave unit outputs a second signal based on the first signal, the second signal is input to at least one of the main breaker and the branch breakers, and at least one of the main breaker and the branch breakers is interrupted based on the second signal.
(7) It is preferred that, in the discharge detection system of (1) or (3) above, wherein the slave unit is further provided with a power feed section and a switch, the power feed section is electrically connectable to a load and receives power supply from the electrical outlet via the switch, and the switch supplies the power from the electrical outlet to the power feed section in a closed state, and if a determination is made that discharge has occurred, changes from the closed state to an open state.
(8) To achieve the above object, a third discharge detection system of the present invention for detecting discharge occurred in a building based on a noise in a high frequency band input through indoor wiring, the discharge detection system includes a discharge detector and a monitoring device, wherein the discharge detector is provided with a noise detection section for detecting the noise superimposed on a voltage or current and a determination section for determining whether discharge has occurred based on an output of the noise detection section, the monitoring device is provided with a reporting section for visually and/or auditorily reporting that discharge has occurred, the discharge detector is electrically connected to an electrical outlet installed in the building, and if determining that discharge has occurred, outputs a first signal and the first signal is input to the monitoring device, and the monitoring device causes the reporting section to operate based on the first signal.
(9) It is preferred that the discharge detection system of (8) above includes a plurality of the discharge detectors, wherein the monitoring device is further provided with a comparison section, the first signal includes information on at least one of a level of the noise, time of detecting the noise, and a duration time of the noise, and the comparison section of the monitoring device compares information on at least one of the level of the noise, the time of detecting the noise, and the duration time of the noise based on two or more of the first signals output from the plurality of the discharge detectors to specify any one of the plurality of the discharge detectors.
(10) It is preferred that, in the discharge detection system of (9) above, all or part of the plurality of the discharge detectors capable of sending and receiving a signal to and from each other and the first signal output from one of the discharge detectors is input to the monitoring device through another discharge detector.
(11) It is preferred that, in the discharge detection system of (8) or (9) above, the monitoring device outputs a second signal based on the first signal and at least one of a main breaker and a plurality of branch breakers is interrupted based on the second signal, the main breaker and the branch breakers configuring a distribution board.
(12) It is preferred that, in the discharge detection system of (9) above, an individual identification number is assigned to each of the plurality of the discharge detectors and the first signal includes information on the individual identification number, and the reporting section of the monitoring device has a configuration capable of displaying the individual identification number of at least one of the discharge detectors based on the first signal.

### Effects of the Invention

The discharge system of the present invention is configured to detect discharge occurred in the entire building by a plurality of slave units (discharge detectors). Each of the plurality of slave units is electrically connected to an electrical outlet installed in the building. The cooperation of the master unit (discharge detector) with the slave units allows thorough and accurate detection of discharge occurred in the entire building without reducing the discharge detection accuracy of the master unit (discharge detector). In addition, the discharge detection system of the present invention allows a plurality of discharge detectors to be extremely readily installed and does not have to enlarge the housing of the distribution board.

### Brief Description of the Drawings

Fig. 1 is a schematic diagram illustrating a discharge detection system according to a first embodiment of the present invention.
Fig. 2 is a schematic diagram illustrating a discharge detection system according to a second embodiment of the present invention.
Fig. 3 is a schematic diagram illustrating a master unit.
Fig. 4 is a schematic diagram illustrating a main configuration of the above master unit.
Fig. 5 is a schematic diagram illustrating a building in which the above discharge detection system is installed.
Fig. 6 is a schematic diagram illustrating a slave unit according to the first embodiment.
Fig. 7 is a schematic diagram illustrating a main configuration of the above slave unit according to the first embodiment.
Fig. 8 is another schematic diagram illustrating the above discharge detection system.
Fig. 9 is another schematic diagram illustrating the above discharge detection system.
Fig. 10 is a schematic diagram illustrating a slave unit according to the second embodiment.
Fig. 11 is a schematic diagram illustrating a main configuration of the above slave unit according to the second embodiment.
Fig. 12 is a schematic diagram illustrating a slave unit according to a third embodiment.
Fig. 13 is a schematic diagram illustrating a main configuration of the above slave unit according to the third embodiment.
Fig. 14 is a schematic diagram illustrating the above discharge detection system and a pseudo-discharge generation circuit.
Fig. 15 is a schematic diagram illustrating a level of a noise stored in the above master unit.
Fig. 16 is another schematic diagram illustrating a discharge detection system according to the third embodiment of the present invention.
Fig. 17 is a schematic diagram illustrating a building in which the above discharge detection system is installed.
Fig. 18 is another schematic diagram illustrating the above discharge detection system.
Fig. 19 is a schematic diagram illustrating a master unit.
Fig. 20 is a schematic diagram illustrating a main configuration of the above master unit.
Fig. 21 is a schematic diagram illustrating a discharge detection system according to a fourth embodiment of the present invention and waveforms of noises detected by two discharge detectors.
Fig. 22 is a schematic diagram illustrating a slave unit.
Fig. 23 is a schematic diagram illustrating a main configuration of the above slave unit.
Fig. 24 is a schematic diagram illustrating a discharge detection system according to a fifth embodiment of the present invention.
Fig. 25 is a schematic diagram illustrating the above discharge detection system and information sent and received between a plurality of discharge detectors.
Fig. 26 is another schematic diagram illustrating the above discharge detection system and information sent and received between the plurality of discharge detectors.

### Modes for Carrying Out the Invention

### 1. Discharge Detection Systems according to First and Second Embodiments

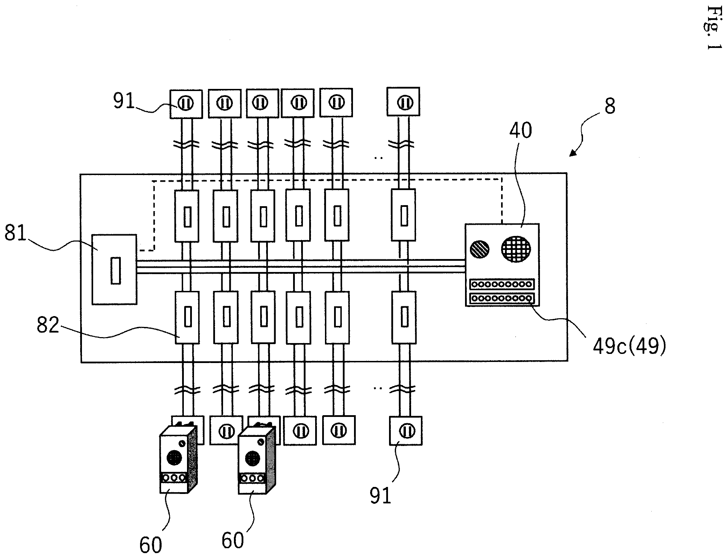

Discharge detection systems according to the first and second embodiments of the present invention are described with reference to Figs. 1 through 15.

### 1.1 Overview of Discharge Detection System

Fig. 1 illustrates a circuit provided in a building and a discharge detection system according to the first embodiment of the present invention. In Fig. 1, the circuit provided in the building is configured with a distribution board 8, indoor wiring, and a plurality of electrical outlets 91. Meanwhile, the discharge detection system in the first embodiment is configured with a master unit 40 and a plurality of slave units 60.

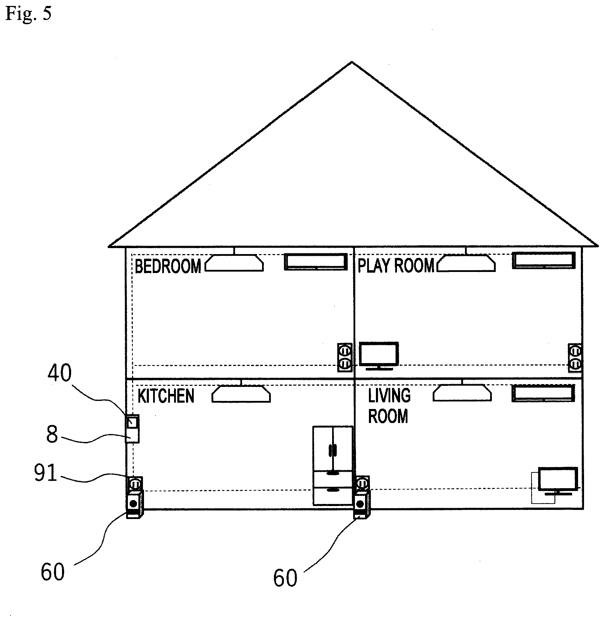

The distribution board 8 is configured with a main breaker 81 and a plurality of branch breakers 82. The main breaker 81 has a primary side electrically connected to outdoor wiring, not shown. The main breaker 81 has a secondary side electrically connected to the plurality of branch breakers 82 via a bus bar or a power line. Each of the branch breakers 82 is electrically connected to the primary side of the indoor wiring installed in a plurality of rooms (refer to Fig. 5) in the building. The indoor wiring in Fig. 1 is illustrated by omitting the middle. The plurality of electrical outlets 91 are respectively installed in the plurality of rooms in the building and are electrically connected to the secondary side of the indoor wiring. To each electrical outlet 91, a plug 79 provided in a load, not shown, is electrically connected. The load refers to various devices that operate by consuming power.

In such a manner, the distribution board 8, the indoor wiring, the electrical outlets 91, and the plurality of circuits including the respective loads are configured in the building. If an accident, such as tracking, a short circuit, and disconnection, occurs in any of the circuit, discharge takes place. The discharge causes a noise in a high frequency band. The noise is superimposed on a voltage and a current of the utility power.

The discharge detection system in the first embodiment detects occurrence of discharge based on a noise generated by discharge. As described above, a discharge detector in the first embodiment is configured with the master unit 40 and the plurality of slave units 60. The master unit 40 is installed in the housing of the distribution board 8. In the housing of the distribution board 8, the master unit 40 is electrically connected to the secondary side of the main breaker 81 and the primary side of each branch breaker 82. The master unit 40 is also electrically connected to the main breaker 81 via a (wired or wireless) signal line indicated by a broken line in Fig. 1. Meanwhile, the plurality of slave units 60 are electrically connected to the respective electrical outlets 91 installed in the plurality of rooms in the building (refer to Fig. 5).

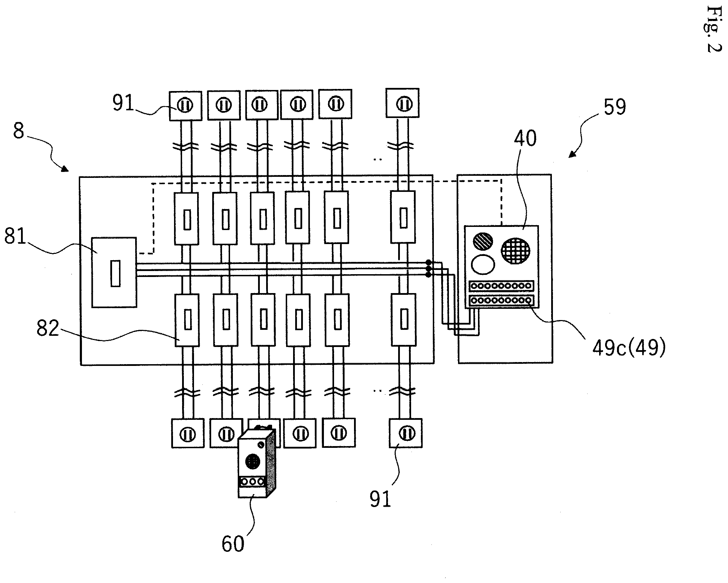

In this situation, as a discharge detection system in the second embodiment illustrated in Fig. 2, the master unit 40 may be configured to be provided separately from the distribution board 8. The master unit 40 separate from the distribution board 8 may be installed at an arbitrary location in the building. The discharge detection system in the second embodiment has the same configuration as that of the discharge detection system in the first embodiment illustrated in Fig. 1 except for providing the master unit 40 separately from the distribution board 8.

### 1.2 Master Unit

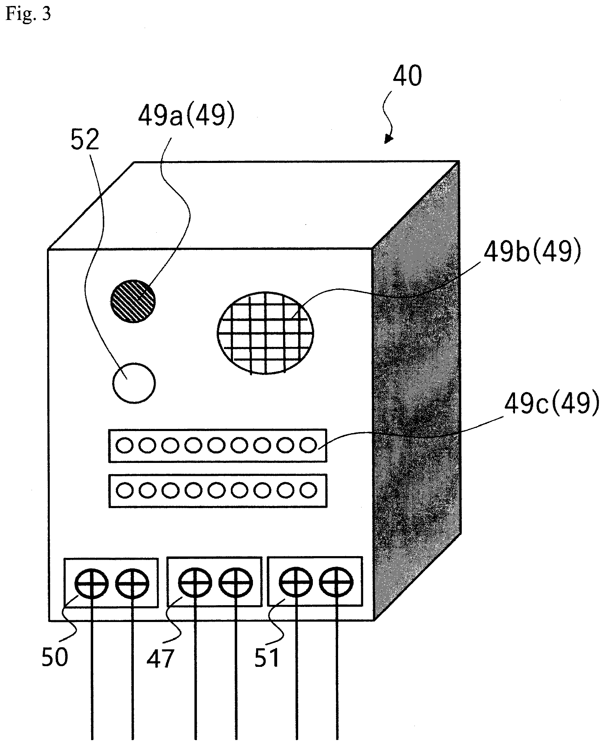

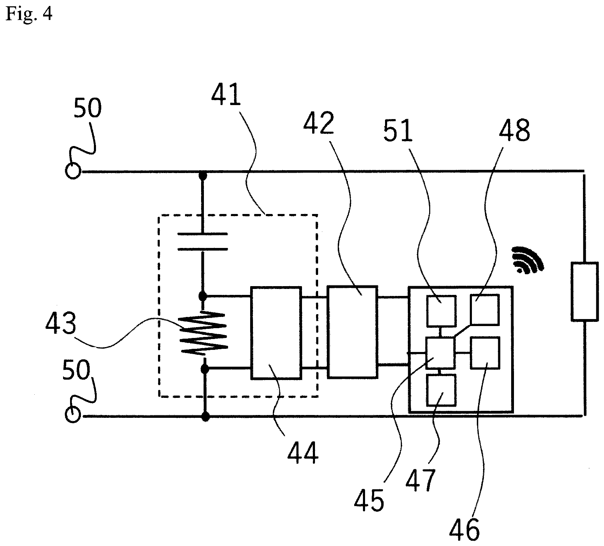

The master unit 40 is described with reference to Figs. 3 and 4. Fig. 3 illustrates the external configuration of the master unit 40. Fig. 4 illustrates the main configuration inside the master unit 40.

As illustrated in Fig. 3, the housing of the master unit 40 has a front surface provided with a plurality of reporting sections 49, input terminals 50, first output terminals 47, second output terminals 51, and a reset button 52. The plurality of reporting sections 49 include a power lamp 49a, a speaker 49b, and an LED display section 49c. Moreover, the reporting sections 49 include processes of an arithmetic section 45 for reporting that discharge has occurred. Hereinafter, the processes of the arithmetic section 45 for reporting that discharge has occurred is referred to as the "reporting section 49" to be distinguished from the power lamp 49a, the speaker 49b, and the LED display section 49c.

The LED display section 49c of the master unit 40 is configured with a plurality of LEDs by the number of, for example, the slave units 60 to be used or more. The plurality of LEDs are arranged in two lines, one above the other, on the front surface of the housing of the master unit 40, and the LEDs individually correspond to the slave units 60 to be used. The LED display section 49c turns on, if any of the slave units 60 detects occurrence of discharge, the LED corresponding to the slave unit 60. A user of the discharge detection system is allowed to specify the slave unit 60 having detected the occurrence of discharge based on the location of the LED turned on in the LED display section 49c.

The input terminals 50 are electrically connected to the secondary side of the main breaker 81 and the primary sides of the plurality of branch breakers 82 illustrated in Fig. 1. The first output terminals 47 are electrically connected to the main breaker 81 illustrated in Fig. 1. The second output terminals 51 outputs information, to the outside, on the occurrence of discharge output from the reporting section 49.

As illustrated in Fig. 4, the master unit 40 is provided with a noise detection section 41, a determination section 42, the arithmetic section 45, a storage section 46, and a communication section 48. The noise detection section 41 is configured with an RC circuit and an amplifier 44. The RC circuit is configured with a capacitor and a resistor 43. The RC circuit passes, without attenuation, frequency components higher than a cutoff frequency among the frequency components of the utility power. The noise in a high frequency band superimposed on the utility power is thus extracted. The output of the noise having passed the RC circuit is amplified by the amplifier 44 and input to the determination section 42.

The determination section 42 determines whether discharge has occurred based on a result of detection of the noise detection section 41. For example, the determination section 42 compares the level of the noise detected by the noise detection section 41 with a threshold set in advance. If the noise level is the threshold or more, the determination section 42 determines whether the noise at the level of the threshold or more continues while a predetermined time set in advance passes. If the noise at the level of the threshold or more continues for the predetermined time, the determination section 42 determines that discharge has occurred. If determining that discharge has occurred, the determination section 42 outputs a signal to the arithmetic section 45.

The arithmetic section 45 executes a plurality of processes related to the occurrence of discharge based on the signal from the determination section 42. Firstly, the arithmetic section 45 outputs sound from the speaker 49b illustrated in Fig. 3 to auditorily report that discharge has occurred. The arithmetic section 45 also turns on the LED display section 49c to visually report that discharge has occurred. The reports by the speaker 49b and the LED display section 49c are stopped by operating the reset button 52 illustrated in Fig. 3. Secondly, the arithmetic section 45 outputs a cutoff signal (first signal) from any of the first output terminals 47. The cutoff signal is input to the main breaker 81 via the (wired or wireless) signal line indicated by the broken line in Fig. 1. The main breaker 81 is thus interrupted. It should be noted that the arithmetic section 45 may be configured to selectively output the cutoff signal to any of the branch breakers 82. Thirdly, the arithmetic section 45 is capable of outputting the information on the occurrence of discharge to the outside via any of the second output terminals 51.

The storage section 46 stores information used for the processes of the arithmetic section 45. The storage section 46 also stores the results of detection of the noise detection section 41, the results of determination of the determination section 42, information obtained from the slave units 60, and the like.

The communication section 48 allows the master unit 40 to send and receive a signal to and from each of the slave units 60. The mode of communication by the communication section 48 may be either wireless or wired communication. The wireless communication mode includes Wi-Fi^{®}, Bluetooth^{®}, infrared, and the like. The wired communication mode is preferably PLC (power line communication) via the indoor wiring. For example, if determining that discharge has occurred, the master unit 40 outputs a signal (first signal) to the slave unit 60 via the communication section 48.

### 1.3 Slave Unit

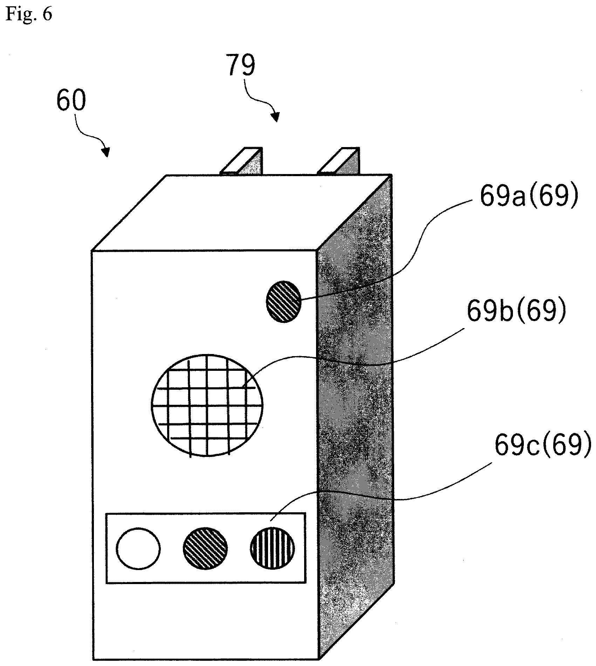

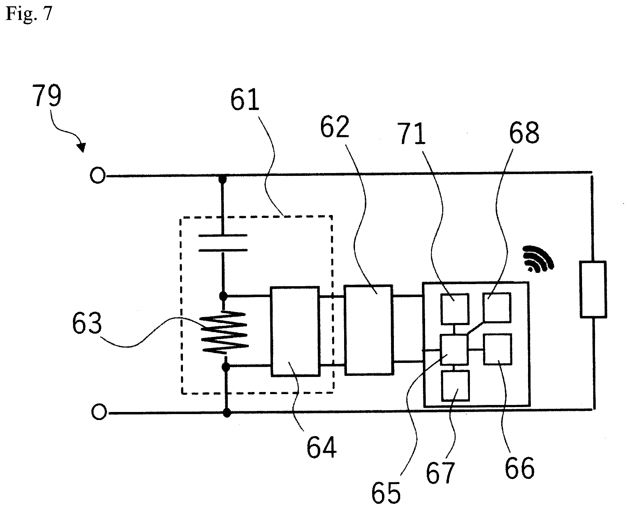

The slave units 60 are described with reference to Figs. 6 and 7. Fig. 6 illustrates the external configuration of one of the slave units 60. Fig. 7 illustrates the main configuration inside the slave unit 60.

The slave unit 60 complements the discharge occurrence detection function of the master unit 40. For example, the level of a noise generated by discharge is attenuated in proportion to the length of wiring. Thus, a location of discharge occurrence farther from the master unit 40 causes a lower level of the noise input to the master unit 40. The slave unit 60 is installed in the electrical outlet 91 at a location difficult to detect occurrence of discharge by the master unit 40. Then, the slave unit 60 illustrated in Figs. 6 and 7 detects a noise generated by discharge and determines whether discharge has occurred. The information on the noise detected by the slave unit 60 and the result of determination that discharge has occurred are input to the master unit 40. Use of both the master unit 40 and the slave unit 60 allows thorough and accurate detection of discharge occurred in the entire building without reducing the discharge detection accuracy of the master unit 40.

As illustrated in Fig. 6, the housing of the slave unit 60 has a front surface provided with a plurality of reporting sections 69. The plurality of reporting sections 69 include a power lamp 69a, a speaker 69b, and an LED display section 69c. Moreover, the reporting sections 69 include processes of an arithmetic section 65 for reporting that discharge has occurred. Hereinafter, the processes of the arithmetic section 65 for reporting that discharge has occurred is referred to as the "reporting section 69" to be distinguished from the power lamp 69a, the speaker 69b, and the LED display section 69c.

The LED display section 69c of the slave unit 60 is configured with, for example, a plurality of LEDs arranged in a horizontal line on the front surface of the housing. The LED display section 69c turns on the LED(s) of the number in accordance with the level of the noise detected by the slave unit 60. The user of the discharge detection system is allowed to understand the magnitude of discharge based on the number of LED(s) turned on in the LED display section 69c.

Meanwhile, the housing of the slave unit 60 has a back surface provided with a plug 79 of type A. The plug 79 is electrically connected to one of the electrical outlets 91 illustrated in Fig. 1. The slave unit 60 receives power supply from the electrical outlet 91 via the plug 79. It should be noted that the plug 79 is not limited to type A and may have a shape other than type A, such as type B, type C, type B3, type BF, type SE, type O, and type 02, for example. In addition, the plug 79 may be configured to be electrically connected to the slave unit 60 via an electric wire.

As illustrated in Fig. 7, the slave unit 60 is provided with a noise detection section 61, a determination section 62, the arithmetic section 65, a storage section 66, a first output terminal 67, a communication section 68, and a second output terminal 71.

The noise detection section 61 is configured with an RC circuit and an amplifier 64. The RC circuit is configured with a capacitor and a resistor 63. The RC circuit passes, without attenuation, frequency components higher than a cutoff frequency among the frequency components of the utility power. The noise in a high frequency band superimposed on the utility power is thus extracted. The output of the noise having passed the RC circuit is amplified by the amplifier 64 and input to the determination section 62.

The determination section 62 determines whether discharge has occurred based on a result of detection of the noise detection section 61. For example, the determination section 62 compares the level of the noise detected by the noise detection section 61 with a threshold set in advance. If the noise level is the threshold or more, the determination section 62 determines whether the noise at the level of the threshold or more continues while a predetermined time set in advance passes. If the noise at the level of the threshold or more continues for the predetermined time, the determination section 62 determines that discharge has occurred. If determining that discharge has occurred, the determination section 62 outputs a signal to the arithmetic section 65.

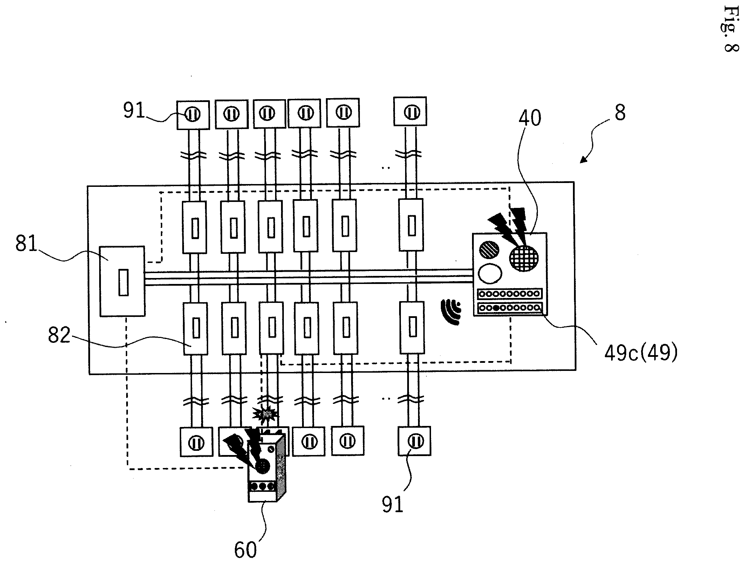

The arithmetic section 65 executes a plurality of processes related to the occurrence of discharge based on the signal from the determination section 62. Firstly, the arithmetic section 65 outputs sound from the speaker 69b illustrated in Fig. 6 to auditorily report that discharge has occurred. The arithmetic section 65 also turns on the LED display section 69c to visually report that discharge has occurred. Secondly, the arithmetic section 65 outputs a signal (second signal) from the first output terminal 67. This signal is input to at least one of the master unit 40, the main breaker 81, and the branch breakers 82 via the (wired or wireless) signal line indicated by the broken line in Fig. 8. In this situation, the signal output from the slave unit 60 is input to a specific branch breaker 82 electrically connected to the slave unit 60 via the electrical outlet 91. Based on the signal output from the slave unit 60, the main breaker 81 or the branch breaker 82 is interrupted. Thirdly, the arithmetic section 65 is capable of outputting the information on the occurrence of discharge to the outside via the second output terminal 71.

The storage section 66 stores information used for the processes of the arithmetic section 65. The storage section 66 also stores the results of detection of the noise detection section 61, the results of determination of the determination section 62, information obtained from the master unit 40, and the like.

The communication section 68 allows the slave unit 60 to send and receive a signal to and from the master unit 40. The mode of communication by the communication section 68 may be either wireless or wired communication. The wireless communication mode includes Wi-Fi^{®}, Bluetooth^{®}, infrared, and the like. The wired communication mode is preferably PLC (power line communication) via the indoor wiring. For example, if determining that discharge has occurred, the slave unit 60 outputs a signal (second signal) to the master unit 40 via the communication section 68.

### 1.4 Cooperation Mode between Master Unit and Slave Units

As illustrated in Figs. 1 and 2, the master unit 40 is electrically connected to the primary sides of the branch breakers 82. This configuration theoretically allows the master unit 40 to detect all discharge occurred in the entire building. It should be noted that a location of discharge occurrence farther from the master unit 40 causes attenuation of the noise generated by the discharge and difficulty in discharge detection by the master unit 40. Upon this, in cooperation with the slave units 60 in various modes, the master unit 40 thoroughly and accurately detects discharge occurred in the entire building.

### 1.4.1 First Mode of Cooperation

The master unit 40 is capable of determining whether discharge has occurred based on a result of detection of the noise detection section 61 of any of the slave units 60. The result of detection of the noise detection section 61 indicates the level of the noise generated by discharge, and the determination section 42 of the master unit 40 determines whether discharge has occurred based on the result of detection of the noise detection section 61 output from the slave unit 60. If determining that discharge has occurred, the master unit 40 outputs a cutoff signal to at least one of the main breaker 81 and the branch breakers 82.

In this situation, the branch breaker 82 to be interrupted by the master unit 40 is a specific branch breaker 82 electrically connected to the slave unit 60 via the electrical outlet 91. That is, the signal output from each slave unit 60 includes an individual identification number of the slave unit 60. The master unit 40 specifies the branch breaker 82 electrically connected to the slave unit 60 based on the individual identification number.

Moreover, the master unit 40 outputs a signal to the slave unit 60 having output the result of detection of the noise detection section 61. Based on this signal, the slave unit 60 causes the speaker 69b and the LED display section 69c to operate to report the occurrence of discharge. For example, the LED display section 69c of the slave unit 60 turns on the LED(s) of the number in accordance with the level of the noise based on the signal output from the master unit 40.

### 1.4.2 Second Mode of Cooperation

The master unit 40 is capable of outputting a cutoff signal to at least one of the main breaker 81 and the branch breakers 82 based on a result of determination of the determination section 62 of the slave unit 60. That is, even if determining that discharge has occurred, the slave unit 60 does not interrupt the main breaker 81 and the branch breaker 82 by itself. The main breaker 81 and the branch breaker 82 are interrupted only by a cutoff signal output from the master unit 40. In this case, the master unit 40 may be configured to determine whether to output a cutoff signal based on a result of determination of the determination section 62 of the slave unit 60.

### 1.5 Propagation of Noise

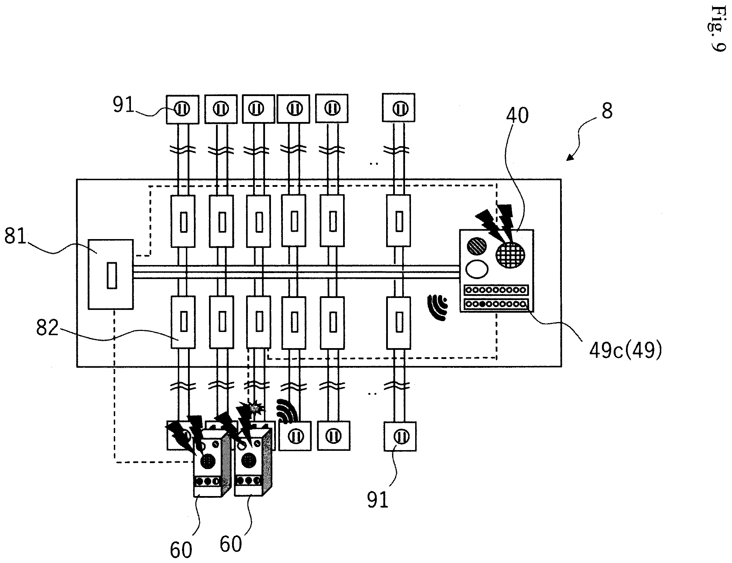

As illustrated in Fig. 9, a noise of discharge occurred in a circuit electrically connected to one of the branch breakers 82 sometimes propagates to a circuit electrically connected to another branch breaker 82. In this case, the respective two slave units 60 sometimes determine that discharge has occurred and output the results of determination to the master unit 40. In this case, the master unit 40 obtains at least one of respective information on a) the time of day when the noise was detected for the first time, b) the average value of the noise levels, and c) the duration time of the noise for the respective two slave units 60 based on the results of detection of the noise detection sections 61 of the respective two slave units 60. The master unit 40 specifies the one slave unit 60 electrically connected to the circuit in which the discharge occurred by comparing at least one of the information on a), b), and c) above obtains from the two slave units 60. The master unit 40 then outputs a cutoff signal to the one branch breaker 82 electrically connected to the one slave unit 60.

It should be noted that, as illustrated in Fig. 9, if another slave unit 60 electrically connected to another branch breaker 82 reports occurrence of discharge based on a propagated noise, the master unit 40 is capable of outputting a signal to this another branch breaker 82 to stop the operation of the speaker 69b and the LED display section 69c.

### 1.6 Omission of Configuration and Function of Slave Units

As illustrated in Figs. 4 and 7, in the discharge detection system of the present embodiment, the master unit 40 has the same configuration and the same functions as those of each slave unit 60. However, the slave units 60 do not have to have the same configuration and the same functions as those of the master unit 40 as long as they are capable of complementing the discharge detection function of the master unit 40. As long as the cooperation of the master unit 40 with the slave units 60 allows thorough and accurate detection of discharge occurred in the entire building, it is possible to omit the configuration of the slave units 60 and to omit the functions of the slave units 60 illustrated in Fig. 7.

**[Table 1]**

| Function | Master Unit | Slave Unit A | Slave Unit B |
|---|---|---|---|
| Noise Detection | ○ | ○ | ○ |
| Discharge Determination | ○ | ○ | ○ |
| Interruption | ○ | ○ | × |
| Report | ○ | ○ | ○ |
| Comparison | ○ | × | × |

The left column in Table 1 indicates various functions of the master unit and the slave units. "Noise Detection" is the function of detecting a noise generated by discharge. The function of "Noise Detection" is realized by the noise detection sections 41 and 61 illustrated in Figs. 4 and 7. "Discharge Determination" is the function of determining whether discharge has occurred. The function of "Discharge Determination" is realized by the determination sections 42 and 62 illustrated in Figs. 4 and 7. "Interruption" is the function of outputting a cutoff signal if a determination is made that discharge has occurred. The function of "Interruption" is realized by the arithmetic sections 45 and 65 illustrated in Figs. 4 and 7. "Report" is the function of reporting occurrence of discharge. The function of "Report" is realized by the speakers 49b and 69b and the LED display sections 49c and 69c illustrated in Figs. 3 and 6 and the arithmetic sections 45 and 65 illustrated in Figs. 4 and 7. "Comparison" is the function of comparing at least one of the information on a) through c) above if a noise generated by discharge propagates and is output from two or more slave units 60. The function of "Comparison" is realized by the determination sections 42 and 62 and the arithmetic sections 45 and 65 illustrated in Figs. 4 and 7.

The "○" in Table 1 indicates to have the function on the left column. The "X" in Table 1 indicates not to have the function on the left column. The master unit in Table 1 has all the functions of "Noise Detection", "Discharge Determination", "Interruption", "Report", and "Comparison". In short, the master unit in Table 1 is provided with all the configurations illustrated in Fig. 4. Meanwhile, the slave unit A in Table 1 does not have the function of "Comparison". In short, the slave unit A is provided with all the configurations illustrated in Fig. 7 while not having a program to realize the function of "Comparison". The slave unit B in Table 1 does not have the functions of "Interruption" and "Comparison". In short, the slave unit B is provided with all the configurations illustrated in Fig. 7 while not having programs to realize the functions of "Interruption" and "Comparison". It should be noted that the plurality of slave units 60 installed in the building may be uniformly adjusted to either one of the slave unit A or the slave unit B in Table 1 or may be adjusted to combination of both the slave unit A and the slave unit B.

**[Table 2]**

| Function | Master Unit | Slave Unit C | Slave Unit D | Slave Unit E | Slave Unit F |
|---|---|---|---|---|---|
| Noise Detection | ○ | ○ | ○ | ○ | ○ |
| Discharge Determination | ○ | × | × | × | × |
| Interruption | ○ | ○ | × | △ | △ |
| Report | ○ | ○ | ○ | ○ | △ |
| Comparison | ○ | × | × | × | × |

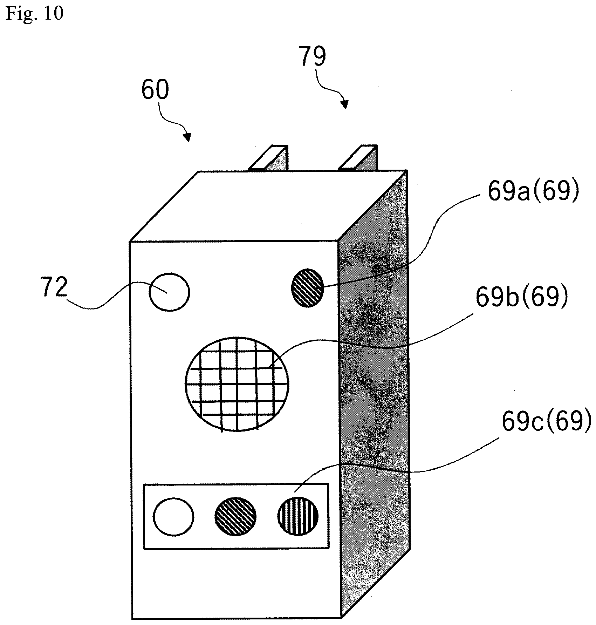

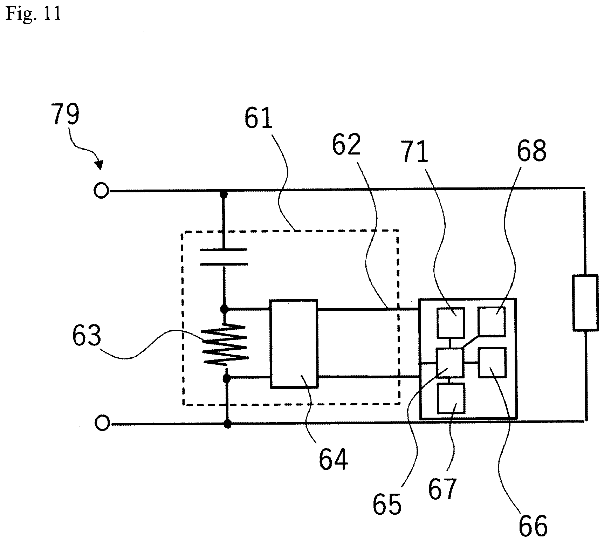

All the slave units C through F in Table 2 do not have the function of "Discharge Determination". Figs. 10 and 11 illustrate the configuration of slave units 60 (slave units C through F in Table 2) according to the second embodiment of the present invention. As illustrated in Fig. 10, each housing of the slave units C through F has a front surface provided with the power lamp 69a, the speaker 69b, and the LED display section 69c. This configuration is the same as that of the slave units 60 illustrated in Fig. 6. In contrast, as illustrated in Fig. 11, the slave units C through F do not have the determination section 62 in Fig. 7. Accordingly, the slave units C through F output results of detection of the noise detection sections 61 to the master unit while not executing determination of whether discharge has occurred. The determination of whether discharge has occurred is executed by the master unit.

The "Δ" in Table 2 indicates that the function on the left column is executed based on a signal output from the master unit. The function of "Interruption" of the slave unit E and the functions of "Interruption" and "Report" of the slave unit F are all executed based on signals output from the master unit. It should be noted that the plurality of slave units 60 installed in the building may be uniformly adjusted to any one of the slave units C through F in Table 2 or may be adjusted to combination of two or more of the slave units C through F. Moreover, the slave units 60 may be adjusted to combination of two or more of the slave units A through F in Tables 1 and 2.

It should be noted that the function of "Discharge Determination" may be omitted from the master unit in Table 2 and the function of "Discharge Determination" may be provided to the main breaker 81 and/or the branch breakers 82 illustrated in Figs. 1 and 2. In this case, the determination section 42 illustrated in Fig. 4 is provided to the main breaker 81 and/or the branch breakers 82. In addition, the slave units C through F in Table 2 output the results of detection of the noise detection sections 61 to the main breaker 81 and/or the branch breakers 82. The determination sections 42 of the main breaker 81 and/or the branch breakers 82 determine whether discharge has occurred based on the results of detection of the noise detection sections 61. If determining that discharge has occurred, the main breaker 81 and/or the branch breakers 82 interrupt the power supply by itself.

### 1.7 Power Feed Section and Switch

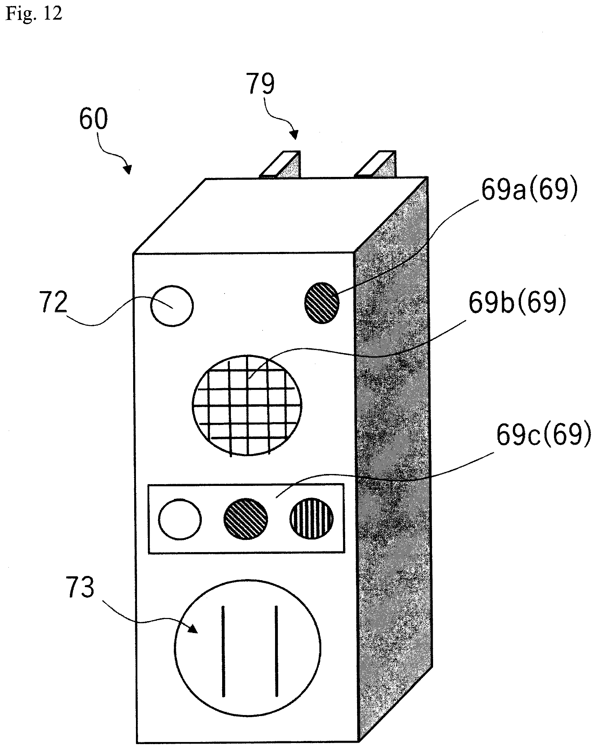

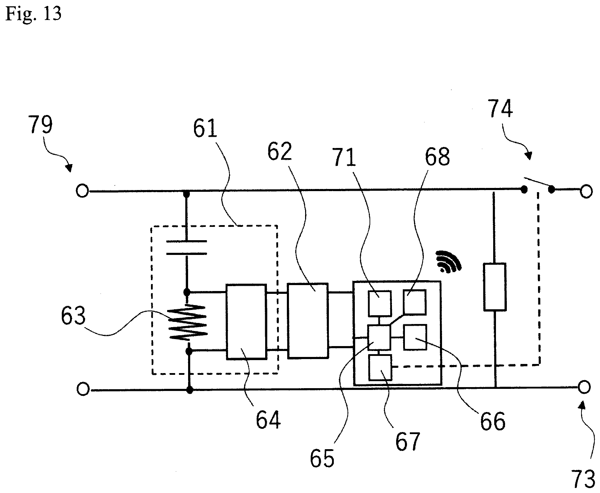

Figs. 12 and 13 illustrate the configuration of slave units 60 according to the third embodiment of the present invention. As illustrated in Fig. 12, the housing of the slave unit 60 has a front surface provided with a power feed section 73 in a shape corresponding to a plug of type A. As illustrated in Fig. 13, the power feed section 73 is electrically connected to the plug 79 provided on the back surface of the housing of the slave unit 60 via a switch 74.

The plug 79 of the slave unit 60 is electrically connected to one of the electrical outlets 91 illustrated in Figs. 1 and 2. The power feed section 73 of the slave unit 60 is thus electrically connected to the electrical outlet 91 via the plug 79 and the switch 74. By electrically connecting a plug of a load, not shown, to the power feed section 73 of the slave unit 60, the power is supplied to the load.

For example, if the determination section 62 of the slave unit 60 determines that discharge has occurred, a signal (second signal) is output from the arithmetic section 65. This signal is input to the switch 74 via the first output terminal 67. The switch 74 changes from the closed state to an open state based on the signal output from the arithmetic section 65. The power supply from the power feed section 73 of the slave unit 60 to the load is thus interrupted.

It should be noted that each slave unit 60 may be configured to be provided with a plurality of power feed sections 73. In this case, the slave unit 60 is preferably provided with a plurality of switches 74 corresponding to the respective power feed sections 73.

### 1.8 Selection of Electrical Outlet to Electrically Connect Slave Unit

As described above, the slave units 60 complement the function of detecting occurrence of discharge of the master unit 40. Then, for thorough and accurate detection of discharge occurred in the entire building, it is effective to install the slave units 60 at locations difficult to detect occurrence of discharge by the master unit 40 in the building. Upon this, a description is given below to a method of selecting an effective location to install the slave unit 60, that is, an effective electrical outlet 91 to which the slave unit 60 is electrically connected.

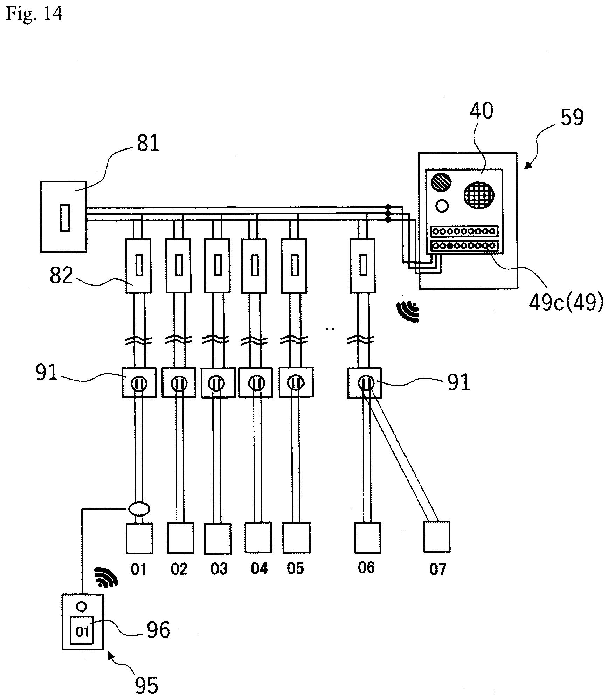

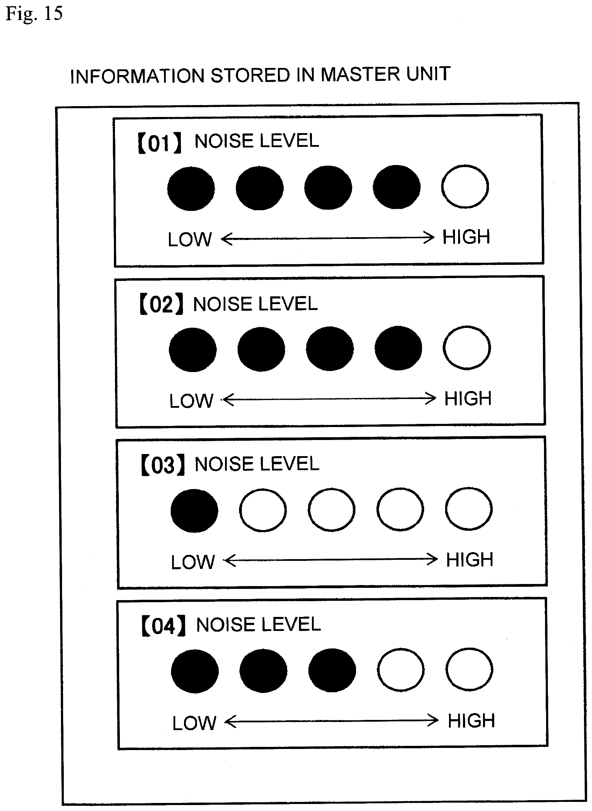

As illustrated in Fig. 14, to select the electrical outlet 91, a pseudo-discharge generator 95 is used. The pseudo-discharge generator 95 is provided with an electric circuit capable of generating discharge, software to generate a circuit number for identification of each of the electrical outlets 91, and a communication section to send a signal to the master unit 40. Meanwhile, the master unit 40 executes a learning mode compatible with the pseudo-discharge generator 95. As illustrated in Fig. 15, in the learning mode, the master unit 40 stores the level of a noise due to discharge generated by the pseudo-discharge generator 95 in association with the circuit number output from the pseudo-discharge generator 95.

As illustrated in Fig. 14, each of the electrical outlets 91 provided in a building is electrically connected to a load. The pseudo-discharge generator 95 generates discharge near an electric wire electrically connecting the load to one of the electrical outlets 91. A noise generated by the discharge is thus superimposed on the voltage and current of the utility power. A user of the discharge detection system generates discharge to the load electrically connected to each of the electrical outlets 91 using the pseudo-discharge generator 95. The pseudo-discharge generator 95 sends one circuit number to the master unit 40 and then generates discharge once. For example, the pseudo-discharge generator 95 generates circuit numbers "01", "02", "03", "04", ... in Fig. 14 in accordance with the number of operation times to output the numbers to the master unit 40. The master unit 40 executes noise detection triggered by the input of the circuit number. As illustrated in Fig. 15, the master unit 40 stores the level of the noise generated by discharge in association with the circuit number. The user refers to the result of detection of the master unit 40 illustrated in Fig. 15 to select the effective electrical outlet 91 to which the slave unit 60 is electrically connected. According to the results of detection illustrated in Fig. 15, the level of the noise of the circuit number "03" is the lowest. It is thus most effective to electrically connect the slave unit 60 to the electrical outlet 91 corresponding to the circuit number "03".

### 2. Discharge Detection Systems according to Third and Fourth Embodiments

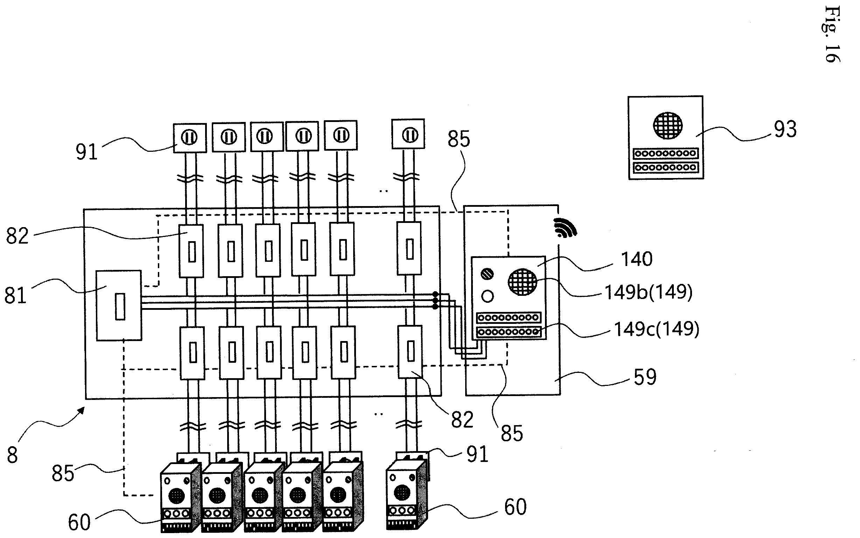

The discharge detection systems according to the third and fourth embodiments of the present invention are described below with reference to Figs. 16 through 26. It should be noted that, in the discharge detection systems of the third and fourth embodiments described below, the same reference sign is given to a configuration identical to that in the first and second embodiments described above to omit the detailed description.

### 2.1 Overview of Discharge Detection System

Fig. 16 illustrates a circuit provided in a building and the discharge detection system according to the third embodiment of the present invention. In Fig. 16, the circuit provided in the building is configured with the distribution board 8, the indoor wiring, and the plurality of electrical outlets 91. Meanwhile, the discharge detection system in the third embodiment is configured with a monitoring device 140 and a plurality of discharge detectors 60.

In Tables 1 and 2 above, the monitoring device 140 is equivalent to the master unit 40 in the first and second embodiments from which the functions of "Noise Detection" and "Discharge Determination" are omitted. The monitoring device 140 is thus not provided with the noise detection section 41 and the determination section 42. The monitoring device 140 is provided with the functions of "Interruption", "Report", and "Comparison" in Tables 1 and 2.

Meanwhile, the plurality of discharge detectors 60 respectively have a configuration approximately identical to that of the slave units 60 in the first and second embodiments. Since the present embodiment does not provide a discharge detector equivalent to the master unit 40, the slave units in the first and second embodiments are rephrased as the "discharge detectors" and the same reference sign is given. Each of the discharge detectors 60 includes all the configuration of each slave unit 60 in the first embodiment and is provided with the functions of "Noise Detection", "Discharge Determination", "Interruption", and "Report" in Table 1.

In the discharge detection system of the present embodiment, cooperation of the plurality of discharge detectors 60 with each other allows thorough and accurate detection of discharge occurred in the entire building. The monitoring device 140 monitors the discharge detectors 60 and visually and/or auditorily reports that discharge has occurred.

### 2.2 Monitoring Device

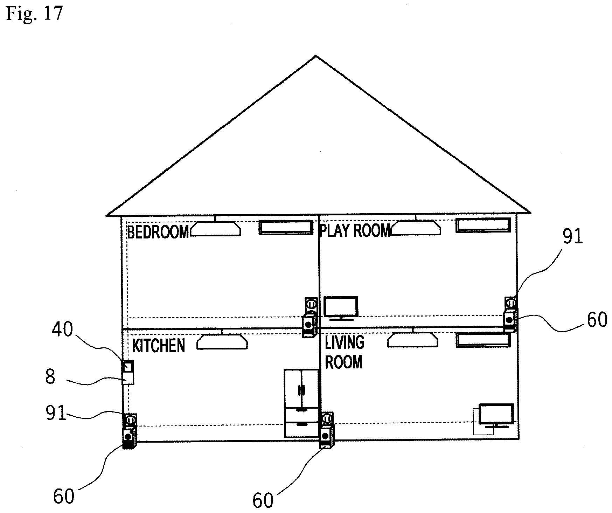

As illustrated in Fig. 16, the monitoring device 140 is provided separately from the distribution board 8 and stored in a housing 59 independent of the distribution board 8. The monitoring device 140 provided separately from the distribution board 8 eliminates the need to enlarge the housing of the distribution board 8. In addition, the monitoring device 140 separate from the distribution board 8 may be installed at an arbitrary location in the building illustrated in Fig. 17.

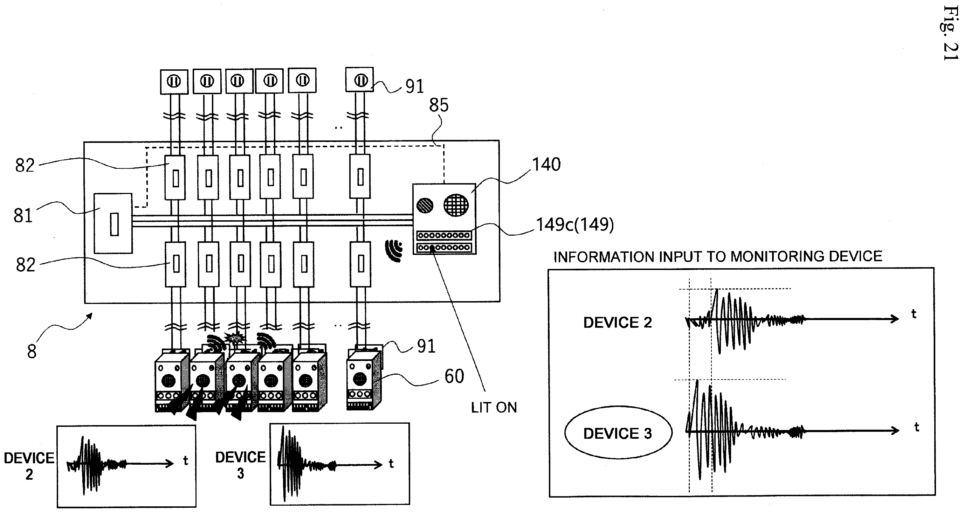

It should be noted that, as the discharge detection system in the fourth embodiment illustrated in Fig. 21, the monitoring device 140 may be configured to be installed in the housing of the distribution board 8. The discharge detection system of the fourth embodiment has the same configuration as that of the discharge detection system of the third embodiment illustrated in Fig. 16 other than the monitoring device 140 installed in the housing of the distribution board 8.

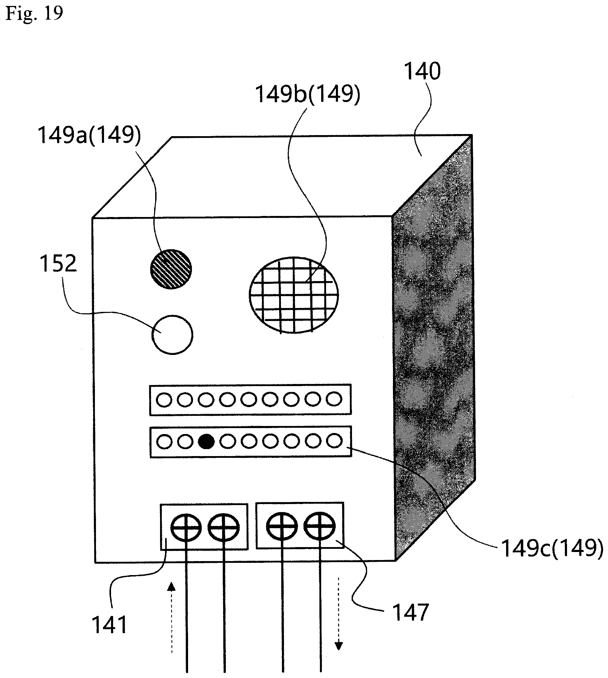

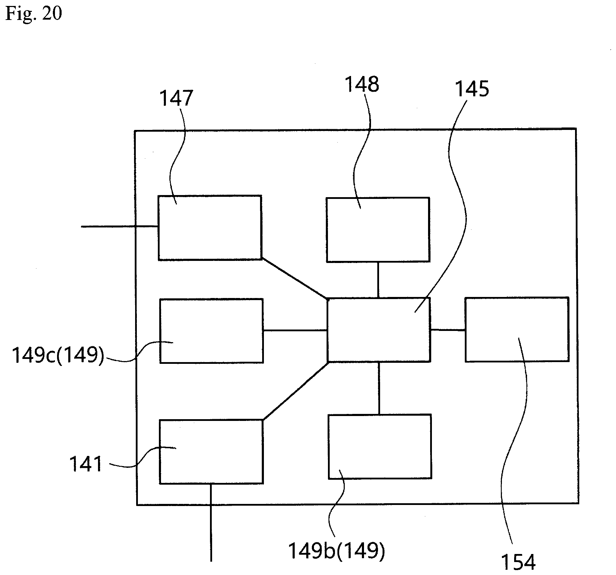

The monitoring device 140 is described with reference to Figs. 19 and 20. Fig. 19 illustrates the external configuration of the monitoring device 140. Fig. 20 illustrates the main configuration inside the monitoring device 140.

As illustrated in Fig. 19, the external configuration of the monitoring device 140 is approximately identical to the external configuration of the master unit 40 in the first and second embodiments. The housing of the monitoring device 140 has a front surface provided with a plurality of reporting sections 149, input terminals 141, output terminals 147, and a reset button 152. The plurality of reporting sections 149 include a power lamp 149a, a speaker 149b, and an LED display section 149c. Moreover, the reporting sections 149 include processes of an arithmetic section 145 for reporting that discharge has occurred. Hereinafter, the processes of the arithmetic section 145 for reporting that discharge has occurred is referred to as the "reporting section 149" to be distinguished from the power lamp 149a, the speaker 149b, and the LED display section 149c.

The LED display section 149c of the master unit 140 is configured with a plurality of LEDs by the number of, for example, the discharge detectors 60 to be used or more. The plurality of LEDs are arranged in two lines, one above the other, on the front surface of the housing of the monitoring device 140, and the LEDs individually correspond to the discharge detectors 60 to be used. The LED display section 149c turns on, if any of the discharge detectors 60 detects occurrence of discharge, the LED corresponding to the discharge detector 60. A user of the discharge detection system is allowed to specify the discharge detector 60 having detected the occurrence of discharge based on the location of the LED turned on in the LED display section 149c.

The input terminals 141 are electrically connected to the secondary side of the main breaker 81 and the primary sides of the plurality of branch breakers 82 illustrated in Fig. 16. The output terminals 147 are electrically connected to the main breaker 81 illustrated in Fig. 16.

As illustrated in Fig. 20, the monitoring device 140 is provided with the arithmetic section 145, a communication section 148, and a comparison section 154. The communication section 148 allows the monitoring device 140 to send and receive a signal to and from each of the discharge detectors 60. The communication section 148 is also used to output a signal to a separate alarm 93 illustrated in Fig. 16. The mode of communication by the communication section 148 may be either wireless or wired communication. The wireless communication mode includes Wi-Fi^{®}, Bluetooth^{®}, infrared, and the like. The wired communication mode is preferably PLC (power line communication) via the indoor wiring. For example, if determining that discharge has occurred, the plurality of discharge detectors 60 output a signal (first signal). This signal is input to the monitoring device 140 via the communication section 148.

The arithmetic section 145 executes a plurality of processes related to the occurrence of discharge based on the signal input via the communication section 148. Firstly, the arithmetic section 145 outputs sound from the speaker 149b illustrated in Fig. 19 to auditorily report that discharge has occurred. The arithmetic section 145 also turns on the LED display section 149c to visually report that discharge has occurred. The reports by the speaker 149b and the LED display section 149c are stopped by operating the reset button 152 illustrated in Fig. 19. Moreover, the arithmetic section 145 outputs a signal to the separate alarm 93 illustrated in Fig. 16 via the communication section 148. This signal causes the alarm 93 to operate. Secondly, the arithmetic section 145 outputs a cutoff signal (second signal) from any of the output terminals 147. The cutoff signal is input to the main breaker 81 via the (wired or wireless) signal lines 85 indicated by the broken lines in Fig. 16. The main breaker 81 is thus interrupted. It should be noted that the arithmetic section 145 may be configured to selectively output the cutoff signal to any of the branch breakers 82 via the signal lines 85.

The comparison section 154 compares information obtained from the plurality of discharge detectors 60 if noise propagation occurs as illustrated in Fig. 21. The comparison section 154 thus specifies one of the discharge detectors 60 electrically connected to the circuit in which the discharge occurred.

As illustrated in Fig. 21, a noise of discharge occurred in a circuit electrically connected to one of the branch breakers 82 sometimes propagates to a circuit electrically connected to another branch breaker 82. In this case, the respective two discharge detectors 60 sometimes determine that discharge has occurred and output the results of determination to the monitoring device 140. In this case, the monitoring device 140 obtains at least one of respective information on a) the time of day when the noise was detected for the first time, b) the average value of the noise levels, and c) the duration time of the noise for the respective two discharge detectors 60 based on the results of detection of the noise detection sections 61 of the respective two discharge detectors 60. The comparison section 154 of the monitoring device 140 specifies the one discharge detector 60 electrically connected to the circuit in which the discharge occurred by comparing at least one of the information on a), b), and c) above obtains from the two discharge detectors 60. The monitoring device 140 then outputs a cutoff signal to the one branch breaker 82 electrically connected to the one discharge detector 60.

### 2.3 Discharge Detector

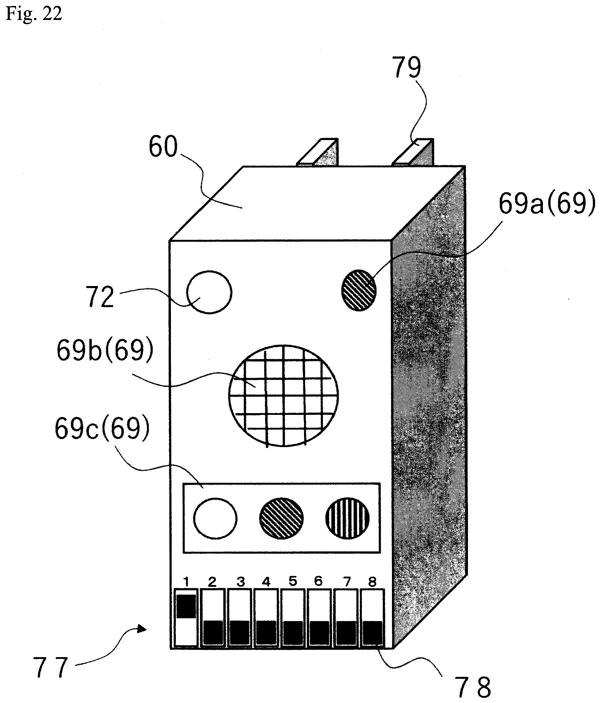

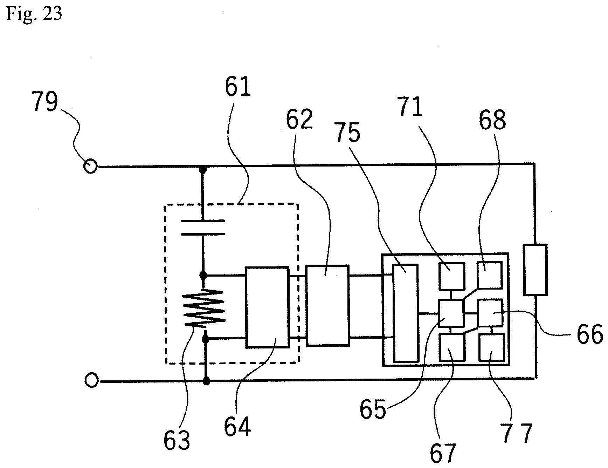

The discharge detectors 60 are described with reference to Figs 22 and 23. Fig. 22 illustrates the external configuration of one of the discharge detectors 60. Fig. 23 illustrates the main configuration inside the discharge detector 60. The discharge detectors 60 in the present embodiment are provided with a configuration identical to that of the slave units 60 in the first and second embodiments and further provided with an identification number setting section (DIP switch) 77 illustrated in Fig. 22.

As illustrated in Fig. 22, the housing of the discharge detector 60 has a front surface provided with a plurality of reporting sections 69. The plurality of reporting sections 69 include a power lamp 69a, a speaker 69b, and an LED display section 69c. Moreover, the reporting sections 69 include processes of an arithmetic section 65 for reporting that discharge has occurred. Hereinafter, the processes of the arithmetic section 65 for reporting that discharge has occurred is referred to as the "reporting section 69" to be distinguished from the power lamp 69a, the speaker 69b, and the LED display section 69c.

The LED display section 69c of the discharge detector 60 is configured with, for example, a plurality of LEDs arranged in a horizontal line on the front surface of the housing. The LED display section 69c turns on the LED(s) of the number in accordance with the level of the noise detected by the discharge detector 60. The user of the discharge detection system is allowed to understand the magnitude of discharge based on the number of LED(s) turned on in the LED display section 69c.

The housing of the discharge detector 60 has the front surface provided with the identification number setting section 77 in a lower portion. In the present embodiment, DIP switches are used as the identification number setting section 77. The identification number setting section 77 is provided with eight small switches 78. These eight switches 78 are selectively turned on/off to allow assignment of an individual identification number to each of the discharge detectors 60. For example, when eight discharge detectors 60 are used for the discharge detection system, different switches 78 from "1" through "8" in the identification number setting section 77 of Fig. 22 are turned on in the respective discharge detectors 60. Thus, the unique individual identification numbers from "0" to "8" are assigned to the respective eight discharge detectors 60. The individual identification numbers are stored in the storage section 66 illustrated in Fig. 23. Then, the unique individual identification numbers are added to signals output from the eight discharge detectors 60. The monitoring device 140 specifies the discharge detector 60 having output the signal based on the individual identification number.

Meanwhile, the housing of the discharge detector 60 has a back surface provided with a plug 79 of type A. The plug 79 is electrically connected to one of the electrical outlets 91 illustrated in Fig. 16. The discharge detector 60 receives power supply from the electrical outlet 91 via the plug 79. It should be noted that the plug 79 is not limited to type A and may have a shape other than type A, such as type B, type C, type B3, type BF, type SE, type O, and type 02, for example. In addition, the plug 79 may be configured to be electrically connected to the discharge detector 60 via an electric wire.

As illustrated in Fig. 23, the discharge detector 60 is provided with the noise detection section 61, the determination section 62, the arithmetic section 65, the storage section 66, the first output terminal 67, the communication section 68, the second output terminal 71, and a power supply section 75.

The noise detection section 61 is configured with an RC circuit and an amplifier 64. The RC circuit is configured with a capacitor and a resistor 63. The RC circuit passes, without attenuation, frequency components higher than a cutoff frequency among the frequency components of the utility power. The noise in a high frequency band superimposed on the utility power is thus extracted. The output of the noise having passed the RC circuit is amplified by the amplifier 64 and input to the determination section 62.

The determination section 62 determines whether discharge has occurred based on a result of detection of the noise detection section 61. For example, the determination section 62 compares the level of the noise detected by the noise detection section 61 with a threshold set in advance. If the noise level is the threshold or more, the determination section 62 determines whether the noise at the level of the threshold or more continues while a predetermined time set in advance passes. If the noise at the level of the threshold or more continues for the predetermined time, the determination section 62 determines that discharge has occurred. If determining that discharge has occurred, the determination section 62 outputs a signal to the arithmetic section 65.

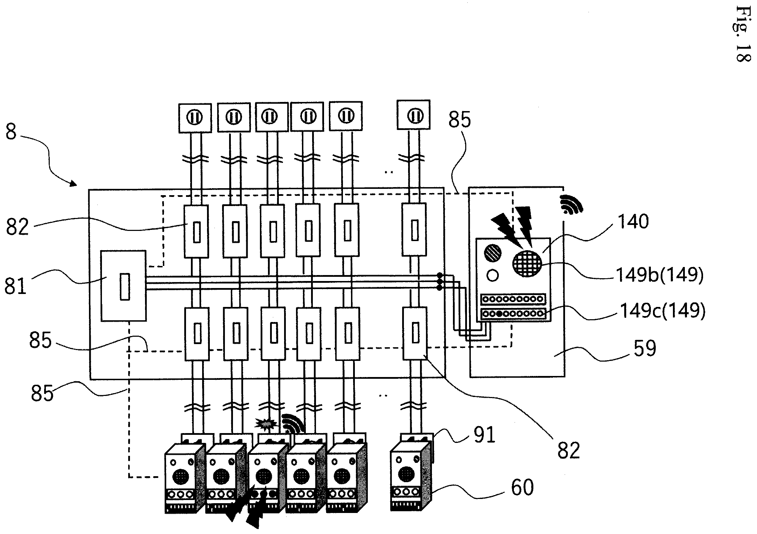

The power supplied from the plug 79 is supplied to the arithmetic section 65 via the power supply section 75. The arithmetic section 65 executes a plurality of processes related to the occurrence of discharge based on the signal from the determination section 62. Firstly, the arithmetic section 65 outputs sound from the speaker 69b illustrated in Fig. 22 to auditorily report that discharge has occurred. The arithmetic section 65 also turns on the LED display section 69c to visually report that discharge has occurred. Secondly, the arithmetic section 65 outputs a signal (first signal) from the first output terminal 67. This signal is input to at least one of the monitoring device 140, the main breaker 81, and the branch breakers 82 via the (wired or wireless) signal lines indicated by the broken lines in Fig. 18. In this situation, the signal output from the discharge detector 60 is input to a specific branch breaker 82 electrically connected to the discharge detector 60 via the electrical outlet 91. Based on the signal output from the discharge detector 60, the main breaker 81 or the branch breaker 82 is interrupted. Thirdly, the arithmetic section 65 is capable of outputting the information on the occurrence of discharge to the outside via the second output terminal 71.

The storage section 66 stores information used for the processes of the arithmetic section 65. The storage section 66 also stores the results of detection of the noise detection section 61, the results of determination of the determination section 62, information obtained from the monitoring device 140, and the like. Moreover, the storage section 66 stores the individual identification numbers set by the identification number setting section 77.

The communication section 68 allows the discharge detector 60 to send and receive a signal to and from the monitoring device 140. The mode of communication by the communication section 68 may be either wireless or wired communication. The wireless communication mode includes Wi-Fi^{®}, Bluetooth^{®}, infrared, and the like. The wired communication mode is preferably PLC (power line communication) via the indoor wiring. For example, if determining that discharge has occurred, the discharge detector 60 outputs a signal (first signal) to the monitoring device 140 via the communication section 68.

### 2.4 Specific Example of Comparison Process by Monitoring Device

As illustrated in Fig. 21, the comparison section 154 of the monitoring device 140 compares the information obtained from the plurality of discharge detectors 60 if noise propagation occurs and thus specifies one of the discharge detectors 60 electrically connected to the circuit in which the discharge occurred.

To the respective discharge detectors 60 illustrated in Fig. 21, the unique individual identification numbers of "01" through "08" are assigned from the left in order in Fig.21. The second discharge detector 60 from the left in Fig.21 is referred to as "Device 2" and the third discharge detector 60 as a "Device 3".

It is assumed that discharge has occurred in a circuit electrically connected to the "Device 3" and the noise has propagated to a circuit electrically connected to the "Device 2". Fig. 21 illustrates the waveforms of the noises detected by the respective "Device 2" and "Device 3". The axis of ordinates of each waveform indicates the level of the noise. The axis of abscissas of each waveform indicates time t. The respective results of detection by the "Device 2" and the "Device 3" are input to the monitoring device 140. The comparison section 154 of the monitoring device 140 compares the results of detection by the "Device 2" and the "Device 3".

For example, the comparison section 154 compares the time of day when the noises were detected for the first time. As illustrated in the two waveforms in Fig. 21, the times of day when the "Device 3" detected the noise for the first time is earlier than the time of day when the "Device 2" detected the noise for the first time. The comparison section 154 also compares the average values of the noise levels. As illustrated in the two waveforms in Fig. 21, the average value of the noise levels detected by the "Device 3" is greater than the average value of the noise levels detected by the "Device 2". The comparison section 154 further compares the duration times of the noises. As illustrated in the two waveforms in Fig. 21, the noise detected by the "Device 3" continued for the time longer than the noise detected by the "Device 2". As a result of such a comparison process, the comparison section 154 specifies that the "Device 3" is electrically connected to the circuit in which the discharge occurred. The monitoring device 140 then outputs a cutoff signal to the main breaker 81 or the one branch breaker 82 electrically connected to the "Device 3".

In the above description, the "Device 2" and the "Device 3" illustrated in Fig. 21 execute the reporting processes by itself in the timing of determining that discharge has occurred. However, the plurality of discharge detectors 60 may execute the reporting processes based on a signal output from the monitoring device 140 after the execution of the comparison process by the comparison section 154 of the monitoring device 140. For example, the monitoring device 140 outputs a signal only to the one discharge detector 60 specified by the comparison section 154. Thus, only the one discharge detector 60 executes the reporting process to announce the occurrence of discharge.

### 2.5 Relay of Information by Plurality of Discharge Detectors

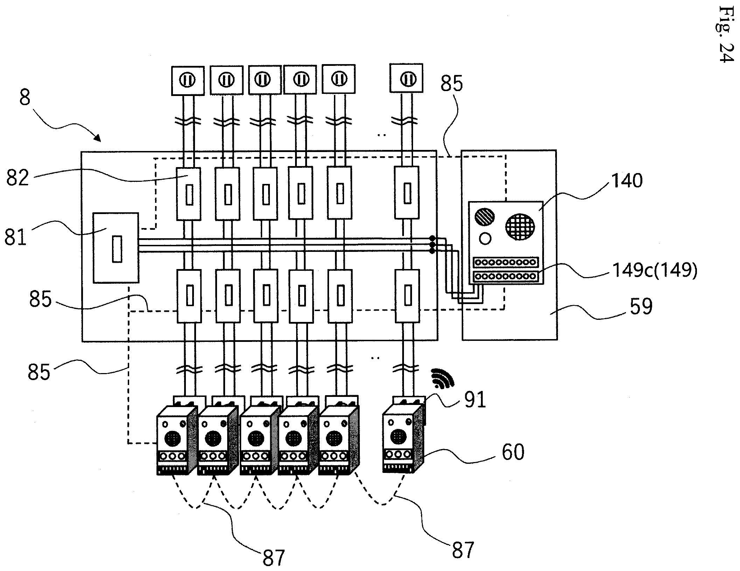

In the building, the plurality of discharge detectors 60 and the monitoring device 140 send and receive a signal via the communication sections 48 and 68. However, depending on the reception of radio waves in the building, not all the discharge detectors 60 are capable of communicating well with the monitoring device 140. Upon this, the plurality of discharge detectors 60 illustrated in Fig. 24 are configured to be capable of sending and receiving a signal via a (wireless or wired) signal line 87. For example, when one of the discharge detectors 60 detects occurrence of discharge, the result of detection by the one discharge detector 60 is output to the monitoring device 140 relayed by other discharge detectors 60. The plurality of discharge detectors 60 provided with such a relay function allows extending the range capable of communication between the plurality of discharge detectors 60 and the monitoring device 140.

### 2.5.1 First Mode of Relay

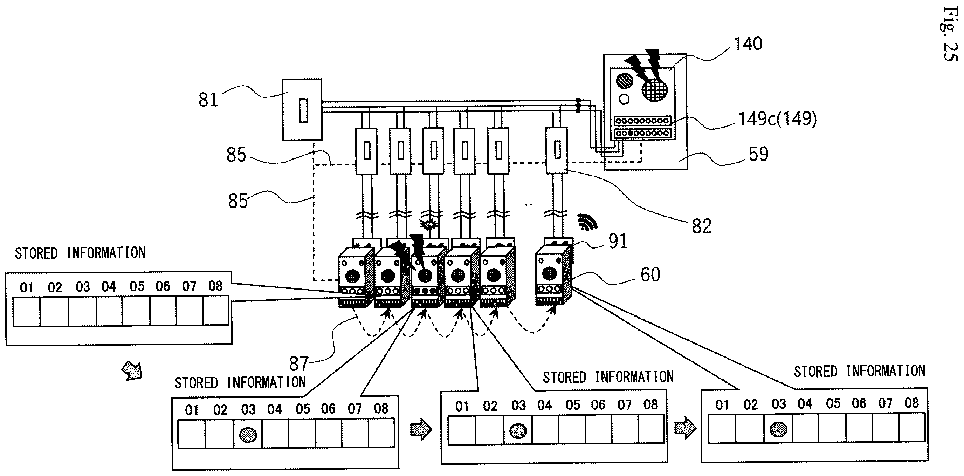

To the plurality of discharge detectors 60 illustrated in Fig. 25, the unique individual identification numbers from "01" to "08" are respectively assigned from the left in order in Fig. 25. In addition, unique addresses are respectively set to the plurality of discharge detectors 60. Based on these addresses, the two discharge detectors 60 sending and receiving a signal are associated.

For example, it is assumed that the third discharge detector 60 from the left in Fig. 25 has detected occurrence of discharge. In this case, the third discharge detector 60 outputs the result of detection together with the individual identification number "03" of itself to the fourth discharge detector 60. Then, the fourth discharge detector 60 stores the individual identification number "03" and the result of detection. Then, the fourth discharge detector 60 outputs the individual identification number "03" and the result of detection to the fifth discharge detector 60. Processes similar to this are repeated by the fifth through eighth discharge detectors 60. At last, the eighth discharge detector 60 sends the individual identification number "03" and the result of detection to the monitoring device 140. The monitoring device 140 outputs a cutoff signal to the main breaker 81 or the one branch breaker 82 electrically connected to the third discharge detector 60.

It should be noted that, in the mode of relay illustrated in Fig. 25, two of the discharge detectors 60 sending and receiving a signal are associated based on the addresses and thus not all the discharge detectors 60 have to relay information. For example, the first and second discharge detectors 60 from the left in Fig. 25 do not relay the individual identification number "03" and the result of detection output from the third discharge detector 60. Thus, the first and second discharge detectors 60 do not store the individual identification number "03" and the result of detection.

### 2.5.2 Second Mode of Relay

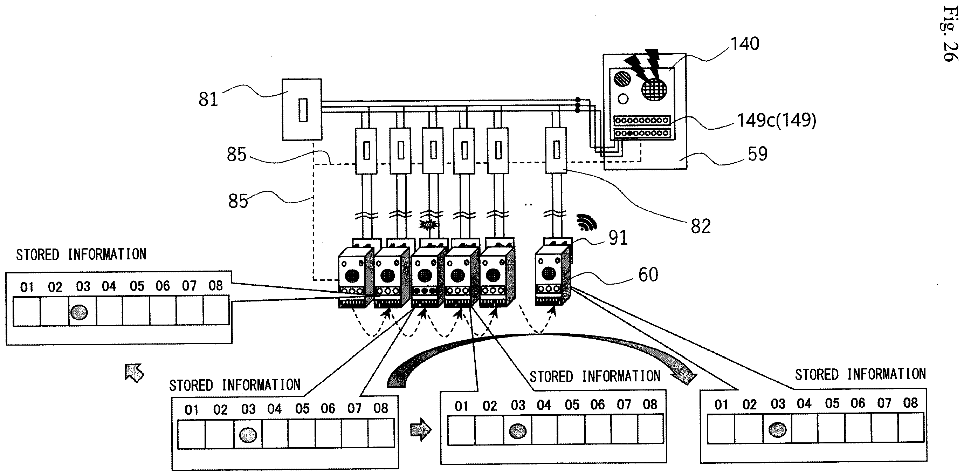

The plurality of discharge detectors 60 illustrated in Fig. 26 are respectively capable of sending and receiving a signal to and from all the other discharge detectors 60. Information output from one of the discharge detectors 60 are input to all the other discharge detectors 60. For example, it is assumed that the third discharge detector 60 from the left in Fig. 26 has detected occurrence of discharge. In this case, the third discharge detector 60 outputs the result of detection together with the individual identification number "03" of itself to all the other discharge detectors 60. All the discharge detectors 60 other than the third one stores the individual identification number "03" and the result of detection output from the third discharge detector 60. Then, the eighth discharge detector 60 closest to the monitoring device 140 sends the individual identification number "03" and the result of detection to the monitoring device 140. The monitoring device 140 outputs a cutoff signal to the main breaker 81 or the one branch breaker 82 electrically connected to the third discharge detector 60.

### 2.5.3 Periodic Communication between Plurality of Discharge Detectors

The plurality of discharge detectors 60 preferably periodically communicate at time intervals set in advance. It is possible to report a failure or theft of any one of the discharge detectors 60 based on breakdown of the periodic communication between at least two of the discharge detectors 60.

### Reference numerals:

- 8: Distribution Board
- 40: Master Unit
- 41: Noise Detection Section
- 42: Determination Section
- 43: Resistor
- 44: Amplifier
- 45: Arithmetic Section
- 46: Storage Section
- 47: First Output Terminal
- 48: Communication Section
- 49: Reporting Section
- 49a: Power Lamp
- 49b: Speaker
- 49c: LED Display Section
- 50: Input Terminal
- 51: Second Output Terminal
- 52: Reset Button
- 60: Slave Unit (Discharge Detector)
- 61: Noise Detection Section
- 62: Determination Section
- 63: Resistor
- 64: Amplifier
- 65: Arithmetic Section
- 66: Storage Section
- 67: First Output Terminal
- 68: Communication Section
- 69: Reporting Section
- 69a: Power Lamp
- 69b: Speaker
- 69c: LED Display Section
- 71: Second Output Terminal
- 73: Power Feed Section
- 74: Switch
- 75: Power Supply Section
- 77: Identification Number Setting Section (DIP Switch)
- 78: Switch
- 79: Plug
- 81: Main Breaker
- 82: Branch Breaker
- 85, 87: Signal Line
- 91: Electrical Outlet
- 93: Alarm
- 95: Pseudo-Discharge Generator
- 140: Monitoring Device
- 141: Input Terminal
- 145: Arithmetic Section
- 147: Output Terminal
- 148: Communication Section
- 149: Reporting Section
- 149a: Power Lamp
- 149b: Speaker
- 149c: LED Display Section
- 152: Reset Button
- 154: Comparison Section

## Claims

1. A discharge detection system for detecting discharge occurred in a building based on a noise in a high frequency band input via indoor wiring, the discharge detection system comprising
a master unit and a slave unit, wherein
each of the master unit and the slave unit is provided with a noise detection section for detecting the noise superimposed on a voltage or current and a determination section for determining whether discharge has occurred based on an output of the noise detection section,
the master unit is electrically connected to a secondary side of a main breaker and primary sides of a plurality of branch breakers, the main breaker and the branch breakers configuring a distribution board,
the slave unit is electrically connected to an electrical outlet installed in the building,
each branch breaker has a secondary side electrically connected to the indoor wiring,
the indoor wiring is electrically connected to the electrical outlet,
if determining that discharge has occurred, the master unit outputs a first signal and the first signal is input to at least one of the main breaker and the branch breakers, and
if determining that discharge has occurred, the slave unit outputs a second signal and the second signal is input to at least one of the master unit, the main breaker, and the branch breakers.

2. The discharge detection system according to Claim 1, wherein at least one of the main breaker and the branch breakers is interrupted based on at least one of the first signal and the second signal.

3. A discharge detection system for detecting discharge occurred in a building based on a noise in a high frequency band input through indoor wiring, the discharge detection system comprising
a master unit and a slave unit, wherein
each of the master unit and the slave unit is provided with a noise detection section for detecting the noise superimposed on a voltage or current,
the master unit is further provided with a determination section for determining whether discharge has occurred based on an output of the noise detection section,
the master unit is electrically connected to a secondary side of a main breaker and primary sides of a plurality of branch breakers, the main breaker and the branch breakers configuring a distribution board,
the slave unit is electrically connected to an electrical outlet installed in the building,
each branch breaker has a secondary side electrically connected to the indoor wiring,
the indoor wiring is electrically connected to the electrical outlet,
if determining that discharge has occurred, the master unit outputs a first signal and the first signal is input to at least one of the main breaker and the branch breakers, and
an output of the noise detection section of the slave unit is input to at least one of the master unit, the main breaker, and the branch breakers.

4. The discharge detection system according to Claim 3, wherein at least one of the main breaker and the branch breakers is interrupted based on the first signal.

5. The discharge detection system according to Claim 3 or 4, wherein, if determining that discharge has occurred based on the output of the noise detection section of the slave unit, the master unit outputs the first signal and the first signal is input to the slave unit.

6. The discharge detection system according to Claim 3, wherein the slave unit outputs a second signal based on the first signal, the second signal is input to at least one of the main breaker and the branch breakers, and at least one of the main breaker and the branch breakers is interrupted based on the second signal.

7. The discharge detection system according to Claim 1 or 3, wherein
the slave unit is further provided with a power feed section and a switch,
the power feed section is electrically connectable to a load and receives power supply from the electrical outlet via the switch, and
the switch supplies the power from the electrical outlet to the power feed section in a closed state, and if a determination is made that discharge has occurred, changes from the closed state to an open state.

8. A discharge detection system for detecting discharge occurred in a building based on a noise in a high frequency band input through indoor wiring, the discharge detection system comprising
a discharge detector and a monitoring device, wherein
the discharge detector is provided with a noise detection section for detecting the noise superimposed on a voltage or current and a determination section for determining whether discharge has occurred based on an output of the noise detection section,
the monitoring device is provided with a reporting section for visually and/or auditorily reporting that discharge has occurred,
the discharge detector is electrically connected to an electrical outlet installed in the building, and if determining that discharge has occurred, outputs a first signal and the first signal is input to the monitoring device, and
the monitoring device causes the reporting section to operate based on the first signal.

9. The discharge detection system according to Claim 8, comprising a plurality of the discharge detectors, wherein
the monitoring device is further provided with a comparison section,
the first signal includes information on at least one of a level of the noise, time of detecting the noise, and a duration time of the noise, and
the comparison section of the monitoring device compares information on at least one of the level of the noise, the time of detecting the noise, and the duration time of the noise based on two or more of the first signals output from the plurality of the discharge detectors to specify any one of the plurality of the discharge detectors.

10. The discharge detection system according to Claim 9, wherein all or part of the plurality of the discharge detectors capable of sending and receiving a signal to and from each other and the first signal output from one of the discharge detectors is input to the monitoring device through another discharge detector.

11. The discharge detection system according to Claim 8 or 9, wherein the monitoring device outputs a second signal based on the first signal and at least one of a main breaker and a plurality of branch breakers is interrupted based on the second signal, the main breaker and the branch breakers configuring a distribution board.

12. The discharge detection system according to Claim 9, wherein
an individual identification number is assigned to each of the plurality of the discharge detectors and the first signal includes information on the individual identification number, and
the reporting section of the monitoring device has a configuration capable of displaying the individual identification number of at least one of the discharge detectors based on the first signal.
